(19) Europäisches Patentamt
European Patent Office
Office européen des brevets

(11) EP 3 910 417 A1

(12) EUROPEAN PATENT APPLICATION

(43) Date of publication:
17.11.2021 Bulletin 2021/46

(51) Int Cl.:
G03F 7/20 (2006.01)

(21) Application number: 20174335.8

(22) Date of filing: 13.05.2020

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• KOULIERAKIS, Eleftherios
5500 AH Veldhoven (NL)

• LANCIA, Carlo
5500 AH Veldhoven (NL)
• GONZALEZ HUESCA, Juan Manuel
5500 AH Veldhoven (NL)
• YPMA, Alexander
5500 AH Veldhoven (NL)

(74) Representative: ASML Netherlands B.V.
Corporate Intellectual Property
P.O. Box 324
5500 AH Veldhoven (NL)

(54) **METHOD FOR DETERMINING AN INSPECTION STRATEGY FOR A GROUP OF SUBSTRATES IN A SEMICONDUCTOR MANUFACTURING PROCESS**

(57) Described is a method and associated computer program and apparatuses for method for making a decision as to whether to inspect a substrate from a group of substrates within a manufacturing process. The method comprises assigning to each substrate of the group of substrates, a probability value describing a probability of complying with a quality requirement, using a model trained to predict compliance with the quality requirement based on pre-processing data associated with the substrate; and deciding whether to inspect each substrate based on the probability value and one or both of: an expected cost of the inspection step and at least one objective value describing an expected value of inspecting the substrate in terms of at least one objective relating to the model.

Fig. 4

**Description**

FIELD

The present invention relates to semiconductor manufacturing processes, in particular methods to make a decision, such as whether a substrate should be inspected, in a semiconductor manufacturing process.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

These tight control loops are generally based on metrology data obtained using a metrology tool measuring characteristics of the applied pattern or of metrology targets representing the applied pattern. In general the metrology tool is based on optical measurement of the position and/or dimensions of the pattern and/or targets. It is intrinsically assumed that these optical measurements are representative for a quality of the process of manufacturing of the integrated circuits.

In addition to control based on optical measurements, also e-beam based measurements may be performed; among which a so-called low voltage measurement using an e-beam tool (as offered by HMI) may be utilized. Such a low voltage contrast measurement is indicative of the quality of electrical contact between layers applied to the substrate.

Any metrology or inspection takes significant time and therefore only a fraction of processed wafers can be inspected in a practical system. The overall benefit to the process of inspection of different wafers will vary from wafer to wafer. As such, an improved method for making decisions such as which wafers should be inspected is desired.

SUMMARY

It is an object of the inventors to address the mentioned disadvantages of the state of the art.

In a first aspect of the invention there is provided a method for determining an inspection strategy for a group of substrates, the method comprising,: assigning to each substrate of the group of substrates, a probability value describing a probability of complying with a quality requirement, using a model trained to predict compliance with the quality requirement based on pre-processing data associated with the substrate; and deciding, for each of said substrates, whether to inspect the substrate based on the probability value and one or both of: an expected cost of the inspection step and at least one objective value describing an expected value of inspecting the substrate in terms of at least one objective relating to the model.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;
Figure 2 depicts a schematic overview of a lithographic cell;
Figure 3 depicts a schematic representation of holistic lithography, representing cooperation between three key technologies to optimize semiconductor manufacturing; and
Figure 4 is a flowchart of a decision making method according to an embodiment of the invention.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:

- a programmable mirror array. More information on such mirror arrays is given in U. S. Patent Nos. 5,296,891 and 5,523,193, which are incorporated herein by reference.
- a programmable LCD array. An example of such a construction is given in U. S. Patent No. 5,229,872, which is incorporated herein by reference.

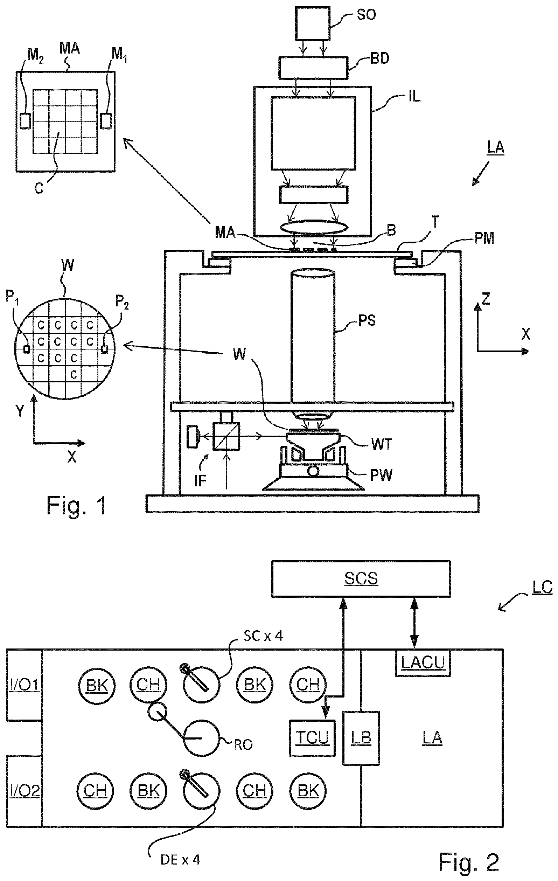

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253 and in PCT publication No. WO99-49504, which are incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks).

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

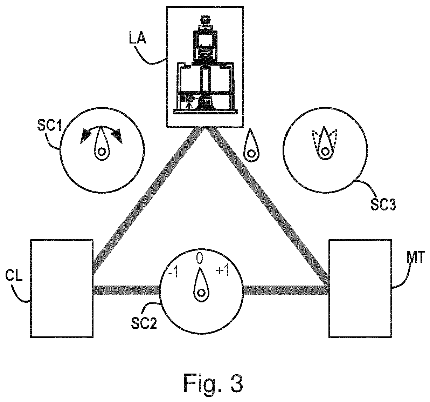

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double white arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT), so as to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus minimizes these focal positon errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may, for example, be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features. The sensitivity of the metrology features to process variations may be different compared to the sensitivity of the product features. In that case, a so-called "Metrology To Device" offset (further also referenced to as MTD) may be determined. To mimic the behavior of product features, the metrology targets may incorporate segmented features, assist features or features with a particular geometry and/or dimension. A carefully designed metrology target should respond in a similar fashion to process variations as the product features. More information on metrology target design can be found in international Patent Application Publication No. WO 2015101458 which is incorporated herein by reference.

The term fingerprint may refer to a main (systematic) contributor ("latent factor") of a measured signal, and in particular a contributor connected to the performance impact on-wafer or to previous processing steps. Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through-lot from reticle alignment measurements, temperature/pressure/servo profiles, etc.). Fingerprints may be comprised within a fingerprint collection, and may be encoded homogenously or heterogeneously therein.

Electrical measurement data is typically obtained after processing of substrates. Typically, when performing electrical metrology to obtain the electrical measurement data, all the dies on the substrates are measured using probes which make (near) contact to the circuits formed during the processing. Various types of measurements may be performed; voltage, current, resistance, capacitance and inductance measurements, for example. These measurements may be performed under different conditions (frequencies, voltage, current for example) and at a plurality of locations across the die. The electrical measurement may comprise an evaluation of whether a particular structure/ feature or device is functional (e.g., within specification). Alternatively, or in addition, the electrical measurement may be categorized according to "bin codes". An electrical measurement associated with a certain measured parameter (current, voltage, resistance, capacitance, inductance) at a certain condition is commonly referred to as a separate "bin code". Hence a typical electrical measurement across a die may be represented by a plurality of graphs, each graph representing a spatial distribution of values associated with a particular bin code. Throughout the text, "bin code" and "electrical characteristic" is used synonymously such that a value of a bin code associated with the substrate is referred to as a value of an electrical characteristic of the substrate. Electrical measurement data may also comprise bit asymmetry data or any other yield parameter.

The properties (minimum value, maximum value, variance or any other statistical measure) of the measured electrical characteristics are important indicators regarding the probability that a certain circuit on a die will be functional. Hence a strong relationship exists between the electrical characteristic and the yield of the process. Hence for yield control, electrical characteristic measurements are indispensable. However, they are also time consuming and are only performed at the end stage of the semiconductor manufacturing process (e.g. when options for correcting non-functional circuits are virtually absent).

Deciding which substrates should be inspected and/or reworked after exposure is an important consideration which will have an impact on throughput and yield. Errors in classification will result in yield wastage, as undetected out-of-speciation/non-functioning devices will be processed, or else trigger too many false alarms, resulting in unnecessary checks and low efficiency. Rework decisions are based on metrology measurement (inspections) that are both costly and time-consuming. Also, the inspection capacity of a fab is usually limited; e.g., to no more than 5% or 10% of the production volume. As a result, only a small number of all wafers produced are inspected. Typically the vast majority of the inspected wafers are found to be within specification (OK). Rework decisions should take place within a short period of time, usually within few minutes.

Currently, there are different selection strategies to decide which wafers should be inspected. These strategies include random selection or fixed selection (e.g., the nth wafer of each lot). Another strategy may be selection based on measurements and experience. A subject-matter expert (SME) decides whether a wafer should be inspected based on custom-KPI (key performance indicator) values and their experience. Such strategies may be implemented singularly or in any combination.

Random or fixed selection strategies might result in a needlessly high engineering operating expense (OPEX). This is because the wafers are not inspected based on quality-related measurements. At the same time, these strategies cannot prevent yield loss as the selection criteria are not designed to inspect abnormal wafers. For the expert based strategy, the SME is likely to introduce high variance and biases in the rework decision. As a consequence, a systematic and reliable rework-decision-process is not likely. Depending on the bias, this strategy can result in large Type I (false positive) or Type II (false negative) errors, leading to high OPEX or yield loss, respectively

In addition to the strategies described, published application WO2018133999 (incorporated herein by reference) describes a method which facilitates the assessment of the wafers by the use of a utility model that is trained to learn the mapping between pre-processing wafer data (e.g., context data) with wafer/device performance, e.g., yield. Pre-processing data or context data may describe which tool or combination of tools were used in processing the wafer, and/or comprise scanner metrology data such as alignment and leveling data. The output of this utility model is used by a semi-supervised algorithm that makes performance predictions based on fab and litho context-data. All wafers are visualized then to the SME by using data transformation and clustering techniques. Performance of the wafers is predicted by either the utility model or the semi-supervised algorithm; labeled wafers which belong to one or more of these clusters provide an indication of the performance of unlabeled wafers which belong to same clusters. The SME then makes a decision to inspect a wafer based on the visualization.

As semi-conductor factories evolve, a timely inspection decision becomes a constraint. Where decisions use expert input, the SME cannot discover patterns leading to identification of potential not-OK (NOK) root-causes, due to the volume of data/KPI they have to analyze. In addition, the expert cannot inspect and analyze such large amount of data in the given time, even if provided with a visualization tool such as described in WO2018133999. While this method provides the SME with a cluster visualization, it is not automated in the sense that all rework decisions still depend on the expert.

It is proposed to use a machine learning strategy for prediction of wafer quality (e.g., rework decision) based on available per-wafer data (e.g., pre-processing data). Either supervised or unsupervised prediction algorithms can be chosen to derive a yield-related prediction; e.g., a prediction of a wafer being either NOK or OK. Additionally, an associated probability value of the wafer being NOK/OK may be provided.

Based on the probability, one or more other objectives and the metrology cost, one or more wafers may be selected for inspection. These objectives may relate to the value (e.g., in terms of one or more informativity metrics) of obtaining metrology data for one or more of: a) verifying whether a wafer is correctly characterized (accuracy of the model), b) accelerating learning process (maturity of the model) and c) discovering new patterns; e.g., OK/NOK patterns (scope of the model). The framework balances these objectives in view of the estimated final yield against the cost of metrology (OPEX). The relative importance of the objectives and cost may be configurable to achieve a flexible framework of rework prediction and wafer selection.

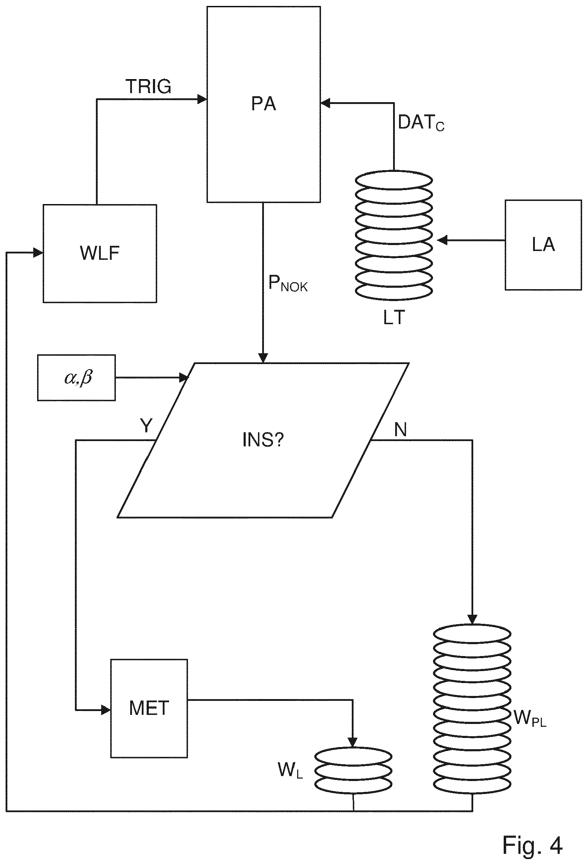

Figure 4 is a flowchart describing an example of a method according to an embodiment. In this embodiment, a machine learning strategy predicts whether each instance (e.g., each wafer) is OK or NOK. This strategy leverages active learning to cope with the twin challenges of small labeled datasets (as few wafers are inspected) and imbalanced datasets in terms of OK vs NOK wafers (as there are typically very few defective wafers). The strategy is not static and may be tuned on demand and/or evolve over time. In this way, it may holistically improve the overall performance (for example a classification or performance metric such as ROC AUC (receiver-operating characteristic area under curve)) while minimizing wafer yield loss and customer engineering OPEX.

The method embeds a prediction algorithm PA and quantifies prediction uncertainty to optimize decision making on which wafers to inspect. Wafers may be optimally selected for inspection with the two-fold aim of accelerating the learning of the embedded prediction algorithm and/or discovering new OK/NOK patterns. The embedded prediction algorithm PA may be either supervised or unsupervised, or even a combination of the two.

A lithographic apparatus LA or scanner processes a group of wafers or wafer lot LT. Pre-processing data or context data (e.g., describing processing history and/or comprising scanner metrology data) for each wafer of the wafer lot LT is passed to the prediction algorithm PA (e.g., a machine learned/machine learning model) which outputs a probability value $P_{NOK}$ describing the probability of each wafer being defective. Based on the probability value $P_{NOK}$, a decision INS? as to whether the wafer should be inspected is made. This decision may be configurable, e.g., via tuning/selecting parameters $\alpha, \beta$ of a beta function used in making the decision. This will be described in more detail below. Those (few) wafers sent for inspection are inspected MET using a suitable metrology tool, with the measurement data (e.g.,

confirmation of OK/NOK status) used to label the wafers $W_L$. Those not inspected are labeled by a category (e.g., OK/NOK) based on the probability value $P_{NOK}$ assigned by the prediction algorithm PA (e.g., by comparing this value to a threshold indicative of non-functionality). For example, instances for which such probability is above a certain threshold, may be labeled as 'NOK'; instances for which such probability is below that threshold, may be labeled as 'OK'. This step has the purpose of building a set of pseudo-labeled wafers $W_{PL}$ for retraining.

With regard to the model used by the prediction algorithm PA, highly imbalanced datasets may use a suitable unsupervised machine learning model. For example, an autoencoder architecture may be used, which is trained only on the dominant/majority class (e.g., OK wafers). For example, the dominant/majority class may correspond to what can be described as normal behavior, with the autoencoder trained using only data which falls in this class. In this way, it will learn the underlying representations of the normal class and will efficiently reconstruct examples which belong to it with a low reconstruction error (or other uncertainty metric). The autoencoder will not be able to capture the underlying structure of a class never observed before and will be unable to reconstruct instances belonging to it, resulting in a high reconstruction error. In this way, instances that do not belong to the majority class can be detected, since the autoencoder is not expected to efficiently reconstruct them, acting as an anomaly detector. In addition, the reconstruction error may be mapped onto a probability of the instance being NOK; for example by means of either a parametric model (like an exponential law) or a nonparametric model (e.g. Kernel Density Estimation).

In the case of more balanced datasets, a supervised prediction algorithm may instead be adopted. The output of the supervised algorithm may be the probability of each instance being NOK; support for probability prediction may be added to the algorithm if needed.

The inspection capacity of a fab is typically limited to a fraction of the production and inspections are costly. This fact has implications on the size of the dataset usually available and the rate at which it can be enriched, ultimately impacting the speed at which a prediction method can be fully learned from scratch or from a small initial dataset.

A decision INS? on which wafers to inspect may be taken by solving an optimization problem with respect to the probability value $P_{NOK}$, with the constraint that the fab capacity inspection is not exceeded. The objective function may incorporate at least the following contributions:

- individual-wafer inspection-value (e.g., a first objective value) with respect to checking that the prediction-accuracy is in spec (e.g., a first objective);
- individual-wafer inspection-value (e.g., a second objective value) with respect to accelerating the learning process (e.g., a second objective);

- individual-wafer inspection-value (e.g., a third objective value) with respect to discovering new OK/NOK patterns (e.g., a third objective);
- cost of exceeding the nominal inspection capacity with respect to the amount of wafers inspected up to the decision time.

The aforementioned published application WO2018133999, for example, describes a general framework for controlling measurements to be performed based on their (expected) informativeness.

An example of a suitable objective function to be minimized may be:

$$f(\xi; \pi) = \langle -\frac{\pi^{\alpha}(1-\pi)^{\beta}}{B(\alpha, \beta)} + \gamma_t, \xi \rangle$$

where:

- the brackets denote scalar product;
- $\xi \in \{0, 1\}^{25}$ expressing that ith wafer selected if and only if $\xi_i = 1$;
- $\pi \in [0, 1]^{25}$ is the vector of estimated NOK probabilities;
- $B(\alpha, \beta) = \frac{\Gamma(\alpha)\Gamma(\beta)}{\Gamma(\alpha+\beta)}$ is the beta function of parameters $\alpha, \beta$;
- $\gamma_t$ is a parameter which constrains the solution to prevent having too many wafers selected.

The scalar product serves the purpose of forming indicators $\xi_i$ ($i = 1, 2, ..., 25$) weighted by the coefficient $-\frac{\pi_i^{\alpha}(1-\pi_i)^{\beta}}{B(\alpha,\beta)} + \gamma_{i,t}$. The contribution to the objective function of selecting a wafer is a positive uniform cost linked to the wafer-inspection capabilities less a cost which depends on the value of inspecting that specific wafer.

The parameters $\alpha$ and $\beta$ determine the reweighing based on a transformation of the interval $[0, 1]$, where the estimated NOK probabilities live. When $\alpha = \beta$, equal weight is put on the regions $P_{NOK} < \frac{1}{2}$ and $P_{NOK} > \frac{1}{2}$, with the extremal values (around 0 and 1) being weighed more (resp. less) if $\alpha = \beta > 1$ (resp. $\alpha = \beta < 1$). If more weight is put on wafers for which $P_{NOK} \simeq 0.5$, learning will accelerate; if more weight is put on wafers for which $|P_{NOK} - 0.5| >> 0$, focus will shift on production control and discovery of new failure modes. Reweighing in a non-symmetric way (e.g. more weight to wafers for which $P_{NOK} \approx 1$ than $P_{NOK} \simeq 0$) is also possible by choosing appropriate values of $\alpha \neq \beta$. As such, a bias can be imposed towards any corresponding quantiles of the probability of the substrate complying with a quality requirement.

The $\alpha$, $\beta$ pair may be set according to one or more of the following methods. A first method may rely on having a set of predefined $\alpha$, $\beta$ pairs, each one addressing a specific aim. For example, specific $\alpha$, $\beta$ pairs may include pairs which:

> i) improve the performance of the algorithm by selecting wafers for inspection which cannot be easily classified;
> ii) improve a desired metric such as AUC;
> iii) detect as many bad wafers as possible.

A second method relies on Reinforcement Learning. The Reinforcement Learning Agent aims to tune the pair of the $\alpha$, $\beta$ parameters, considering the following Reinforcement Learning setting:

- State: Corresponds to the predicted probability of each wafer to be NOK and to the current combination of $\alpha$, $\beta$.
- Action: Adjust $\alpha$, $\beta$ and decide which wafers should be inspected.
- Reward: the improvement of a performance metric of the classification algorithm. The reward may also be based on any costs related to a metrology tool sitting idle because the agent is not sending wafers to inspect.

The parameter $\gamma_t$ prevents there being too many selected wafers in the optimal solution. The subscript t indicates that the parameter may vary over time. For example, while the aforesaid exemplary 5% inspection capacity translates to roughly 1 wafer per lot, the system can decide not to inspect any wafers in a lot and instead inspect more wafers in a later lot. The optimal selection of N wafers to be inspected (with N not necessarily 1) is a very challenging task for existing methods which rely on expert decision. Besides the aforementioned potential bias, the choice is combinatorically complex for a human: picking only 2 wafers from a lot requires a comparison of 300 candidate wafer pairs. In addition, the automated inspection decision performed by the proposed machine learning strategy is superior for time-constrained decisions (such as needs to be taken in a fab after exposing a lot) because no human factor is in the loop. The advantage of this formulation is that the relative weights of these contributions in the objective function can be altered on demand, giving freedom for a user to build their own customized product. The presence of the parameter $\gamma_t$ term in the objective function enables the inspection capacity to be handled dynamically.

In an embodiment, there may be periodic retraining to improve the performance of the machine learning strategy and/or to learn new OK/NOK patterns. The machine learning strategy contributes to the enlargement/creation of two datasets: one containing labeled OK/NOK wafers $W_L$ and the other containing predicted OK/NOK wafers $W_{PL}$. The retraining is done on these periodically-enlarged datasets. This retraining is signified in Figure 4 by the feedback loop from the labeled $W_L$ and pseudo-labeled wafers $W_{PL}$ to a weighted loss function WLF which assesses the performance of the prediction based on the actual labeled wafers $W_L$. Should this performance not meet a threshold for acceptability, a trigger TRIG may be generated to trigger retraining of the prediction algorithm PA. In addition, the loss function WLF may be adapted in order to focus on understanding the most recent patterns in the data or to account for the uncertainty of the predicted pseudo-labels.

The nature of a semi-conductor manufacturing process leads to data evolving over time, generating changes in the underlying data distribution. This scenario, where the distribution of features and labels p(X,y) is not stationary but drift from time to time is known as concept drift. A number of scenarios illustrating this will now be presented:

When a new unseen substrate is exposed, the objective function can adapt automatically by reverting to an initial setup. For example, if it is deemed important to accelerate the learning process (i.e., described with the contributor: individual-wafer inspection-value with respect to accelerating the learning process) for unseen wafers, as soon as a new substrate is identified, the weight for this contributor may be increased using the substrate ID from the scanner data.

In another example, concept drift e.g., due to a change in the underlying data distribution (which may be as a result of changes in the process or scanner natural behavior) may be addressed by monitoring the performance of the prediction algorithm. Some of the true labels (inspected wafers $W_L$) are available after the predictions are made, which can trigger a periodic retraining step in order to provide an up-to-date model. A prediction performance delta may be quantified to provide a measure of the magnitude of the data distribution change. Based on this prediction performance delta, the objective function's contributors may be varied/adapted: e.g., the larger the drop in performance, the more the weights may be varied towards an initial setup, as this is indicative of a new initial state with a new data distribution. The parameters $\alpha$ and $\beta$ may be maintained proportionally with the prediction performance (e.g. a classification or performance metric such as AUC): e.g., the better the performance, the more focus on selecting only NOK wafers. The classification model retraining may be triggered TRIG when the prediction performance is lower than a (e.g., customized) performance threshold.

In summary, therefore, a decision making framework is described which decreases engineering OPEX by optimizing inspection decision making based on cost and constrained to fab capacity. The yield loss is expected to decrease since the rework decision is based anomalies detected by the proposed machine learning strategy. The machine learning strategy is able to deal with both small and/or imbalanced datasets, which is a normal scenario in the lithography industry. The proposed strategy provides a well performing OK/NOK predictor faster than any existing solution. The proposed approach delivers consistently faster recommendations than an expert, something that is desirable in the evolving semiconductor industry. The impact of the human factor (as well as the bias introduced by it) on inspection decisions is diminished since the assessment of wafers is automated and based on machine learning.

The optimization problem is flexible and can be adapted to particular requirements, so it could be used either to achieve a good performance faster or to keep learning from "known" situations. Advances in interpretability of machine learning may also pinpoint the reason why wafers are flagged as OK or NOK and expand the understanding of wafer-quality assessment.

Transfer Learning methods can facilitate fast prototyping and development of machine learning algorithms which require less training data and are capable of supporting rework decisions on new systems. Mutual patterns between OK and NOK wafers exist among many systems which are expected to be captured by the proposed machine learning strategy.

The retraining can be deployed in such a way that the algorithm training focuses more on understanding the structure of recent anomalies compared to anomalies observed in the past. This does not mean that past anomalies cannot be detected going forward, only that the algorithm prioritizes the understanding of recent anomalies compared to anomalies observed long ago. In this way, the system is able to deal with one of the main challenges in the industry: concept drift.

Further embodiments of the invention are disclosed in the list of numbered clauses below:

1. A method for determining an inspection strategy for a group of substrates, the method comprising:

assigning to each substrate of the group of substrates, a probability value describing a probability of complying with a quality requirement, using a model trained to predict compliance with the quality requirement based on pre-processing data associated with the substrate; and
deciding, for each of said substrates, whether to inspect the substrate based on the probability value and one or both of: an expected cost of the inspection and at least one objective value describing an expected value of inspecting the substrate in terms of at least one objective relating to the model.

2. A method according to clause 1, wherein said at least one objective comprises at least one of:

monitoring and/or improving performance of the model according to one or more performance metrics;
accelerating learning of the model;
discovering new patterns to be recognized by the model.

3. A method according to clause 1 or 2, wherein said deciding step is configurable such that the decision can be configured to:

impose a bias towards corresponding quantiles of the probability of the substrate complying with the quality requirement.

4. A method according to any preceding clause, wherein said deciding step is configurable such that said at least one objective is configurable and/or selectable.

5. A method according to clause 3 or 4, wherein said configurability of said deciding step is realized via configurable parameters of an objective function used in said deciding step.

6. A method according to clause 5, wherein said objective function comprises a binary vector indicating which substrates are selected for inspection weighted by a coefficient dependent on said probability value, expected cost and said configurable parameters.

7. A method according to clause 6, wherein the binary vector and weighting is defined for each substrate in the group of substrates.

8. A method according to clause 6 or 7, wherein said deciding step comprises minimizing said objective function for different candidate binary vectors, subject to a constraint based on said expected cost.

9. A method according to clause 8, wherein said constraint imposes a maximum number of substrates which can be inspected over a time period.

10. A method according to clause 8 or 9, wherein said constraint is implemented by a constraint parameter in said weighting.

11. A method according to clause 8, 9 or 10, wherein said constraint is configurable and/or variable over time.

12. A method according to any of clauses 5 to 11, wherein said weighting is dependent on a beta function of said configurable parameters.

13. A method according to any of clauses 5 to 12, wherein a set of said configurable parameters is selected from a plurality of pre-defined sets of said configurable parameters so as to select and/or configure said objective.

14. A method according to any of clauses 5 to 13, comprising using a reinforcement learning agent to tune said configurable parameters to improve a performance metric and/or cost metric of the model.

15. A method according to any preceding clause, further comprising:

labeling selected substrates according to the result of the inspection;
labeling remaining substrates according to said probability value assigned thereto; and evaluating performance of said model based on said labeling.

16. A method according to clause 15, further comprising triggering retraining of the model based on the step of evaluating performance.

17. A method according to any preceding clause, wherein the pre-processing data comprises one or both of:

context data describing a processing history of each substrate; and
pre-processing metrology data performed prior to an exposure step on each substrate.

18. A method according to clause 17, wherein said pre-processing metrology data comprises one or both of alignment data and leveling data.

19. A method according to any preceding clause, further comprising inspecting the selected substrates using an inspection tool.

20. A computer program comprising program instructions operable to perform the method of any of clauses 1 to 18, when run on a suitable apparatus.

21. A non-transient computer program carrier comprising the computer program of clause 20.

22. A processing system comprising a processor and a storage device comprising the computer program of clause 20.

23. A lithographic apparatus comprising the processing system of clause 22.

24. A metrology device comprising the processing system of clause 22 and further operable to perform the method of clause 19.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for determining an inspection strategy for a group of substrates, the method comprising:

assigning to each substrate of the group of substrates, a probability value describing a probability of complying with a quality requirement, using a model trained to predict compliance with the quality requirement based on pre-processing data associated with the substrate; and
deciding, for each of said substrates, whether to inspect the substrate based on: the probability value, an expected cost of inspecting the substrate, and at least one objective value describing an expected value of inspecting the substrate in terms of at least one objective relating to the model.

2. A method as claimed in claim 1, wherein said at least one objective comprises at least one of:

monitoring and/or improving performance of the model according to one or more performance metrics;
accelerating learning of the model;
discovering new patterns to be recognized by the model.

3. A method as claimed in claim 1 or 2, wherein said deciding step is configurable such that the decision can be configured to impose a bias towards corresponding quantiles of the probability of the substrate complying with the quality requirement.

4. A method as claimed in any preceding claim, wherein said deciding step is configurable such that said at least one objective is configurable and/or selectable.

5. A method as claimed in claim 3 or 4, wherein said configurability of said deciding step is realized via configurable parameters of an objective function used in said deciding step.

6. A method as claimed in claim 5, wherein said objective function comprises a binary vector indicating which substrates are selected for inspection weighted by a coefficient dependent on said probability values, expected cost and said configurable parameters.

7. A method as claimed in claim 6, wherein the binary vector and weighting are defined for each substrate in the group of substrates.

8. A method as claimed in claim 6 or 7, wherein said deciding step comprises minimizing said objective function for different candidate binary vectors, subject to a constraint based on said expected cost.

9. A method as claimed in claim 8, wherein said constraint imposes a maximum number of substrates which can be inspected over a time period.

10. A method as claimed in claim 8 or 9, wherein said constraint is implemented by a constraint parameter in said weighting.

11. A method as claimed in any of claims 5 to 10, comprising using a reinforcement learning agent to tune said configurable parameters to improve a performance metric and/or cost metric of the model.

12. A method as claimed in any preceding claim, further comprising:

labeling selected substrates according to the result of the inspection;
labeling remaining substrates according to said probability value assigned thereto; and
evaluating performance of said model based on said labeling.

13. A method as claimed in claim 12, further comprising triggering retraining of the model based on the step of evaluating performance.

14. A method as claimed in any preceding claim, wherein the pre-processing data comprises one or both of:

context data describing a processing history of each substrate; and
pre-processing metrology data acquired prior to an exposure step on each substrate.

15. A method as claimed in claim 14, wherein said pre-processing metrology data comprises one or both of alignment data and leveling data.

Fig. 1

Fig. 2

Fig. 3

Fig. 4

Europäisches
Patentamt
European
Patent Office
Office européen
des brevets

# EUROPEAN SEARCH REPORT

Application Number

EP 20 17 4335

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2016/128189 A1 (ASML NETHERLANDS BV [NL]) 18 August 2016 (2016-08-18) | 1,4,5, 14,15 | INV. G03F7/20 |
| Y | * paragraph [0032] - paragraph [0040] * <br> * figures 2-4 * | 2,3,6-13 | |
| Y | WO 2017/117568 A1 (KLA-TENCOR CORP [US]) 6 July 2017 (2017-07-06) | 2 | |
| A | * page 31, line 4 - page 32, line 9 * | 1 | |
| Y | WO 2020/064544 A1 (ASML NETHERLANDS BV [NL]) 2 April 2020 (2020-04-02) | 3 | |
| A | * paragraph [0143] - paragraph [0144] * <br> * figures 8,10 * | 1 | |
| Y | WO 2017/067748 A1 (ASML NETHERLANDS BV [NL]) 27 April 2017 (2017-04-27) | 6-10,12 | |
| A | * paragraph [0224] - paragraph [0228] * | 1 | |
| Y | WO 2019/191319 A1 (JUNO DIAGNOSTICS INC [US]) 3 October 2019 (2019-10-03) | 11 | |
| A | * paragraph [0189] * | 1 | TECHNICAL FIELDS SEARCHED (IPC) |
| Y | US 2020/051235 A1 (MAJUMDAR AMITAVA [US] ET AL) 13 February 2020 (2020-02-13) | 13 | G03F |
| A | * paragraph [0058]; figures 1,2 * | 1 | |

The present search report has been drawn up for all claims

| Place of search | Date of completion of the search | Examiner |
|---|---|---|
| Munich | 4 November 2020 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 20 17 4335

04-11-2020

| Patent document cited in search report | | Publication date | Patent family member(s) | | Publication date |
|---|---|---|---|---|---|
| WO 2016128189 | A1 | 18-08-2016 | TW | 201640229 A | 16-11-2016 |
| | | | US | 2018031981 A1 | 01-02-2018 |
| | | | US | 2020096871 A1 | 26-03-2020 |
| | | | WO | 2016128189 A1 | 18-08-2016 |
| WO 2017117568 | A1 | 06-07-2017 | CN | 108475351 A | 31-08-2018 |
| | | | EP | 3398123 A1 | 07-11-2018 |
| | | | JP | 2019508789 A | 28-03-2019 |
| | | | KR | 20180090385 A | 10-08-2018 |
| | | | WO | 2017117568 A1 | 06-07-2017 |
| WO 2020064544 | A1 | 02-04-2020 | TW | 202020577 A | 01-06-2020 |
| | | | WO | 2020064544 A1 | 02-04-2020 |
| WO 2017067748 | A1 | 27-04-2017 | KR | 20180070658 A | 26-06-2018 |
| | | | TW | 201719785 A | 01-06-2017 |
| | | | US | 2018314168 A1 | 01-11-2018 |
| | | | WO | 2017067748 A1 | 27-04-2017 |
| WO 2019191319 | A1 | 03-10-2019 | CA | 3095030 A1 | 03-10-2019 |
| | | | WO | 2019191319 A1 | 03-10-2019 |
| US 2020051235 | A1 | 13-02-2020 | US | 2020051235 A1 | 13-02-2020 |
| | | | WO | 2020033107 A1 | 13-02-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- US 5229872 A
- US 6952253 B
- WO 9949504 A
- US 20100214550 A
- US 20070085991 A
- WO 2011081645 A
- US 20060016561 A
- US 20120008127 A
- WO 2015101458 A
- WO 2018133999 A